# EUROPEAN PATENT APPLICATION

(11) **EP 1 734 654 A1**
(43) Date of publication of application: **20.12.2006**
(21) Application number: 05728856.5
(22) Date of filing: 04.04.2005
(51) Int. Cl.: H03H 9/25, H03H 3/08, H03H 9/64

(54) **SURFACE ACOUSTIC WAVE FILTER AND MANUFACTURING METHOD THEREOF**

(30) Priority: 08.04.2004 JP 2004113881
(71) Applicant: MURATA MANUFACTURING CO., LTD., Nagaokakyo-shi, Kyoto 617-8555 (JP)
(72) Inventor: TAKAMINE, Yuichi; c/o Murata Manufacturing Co. Ltd, Kyoto 6178555 (JP)
(74) Representative: Thévenet, Jean-Bruno
(86) International application number: PCT/JP2005/006608
(87) International publication number: WO 2005/099090

(57) **Abstract**

A surface acoustic wave filter which can prevent the formation of large voids when pressing a resin sheet covering a device chip while heating the resin sheet, and a method of producing the same are provided.

In a device chip 10, a principal surface 11a of a piezoelectric substrate 11 having a wiring pattern including IDTs 14 and pads 16 electrically connected to the IDTs 14 is disposed so as to oppose a mount board 2, with the pads 16 being electrically connected to lands 3 of the mount board 2 through bumps 4. A resin film 6 covers the other principal surface 11b of the piezoelectric substrate 11 and the other principal surface of the mount board 2 to seal the device chip 10. In the piezoelectric substrate 11, the principal surface 11a is relatively large and the other principal surface 11b is relatively small.

## Description

### Technical Field

The present invention relates to a surface acoustic wave filter and a method of producing the same.

### Background Art

As with generally used LSIs, for surface acoustic wave filters, various packages having external dimensions that are about the same as those of chip size packages (CSPs), that is, device chips have been proposed.

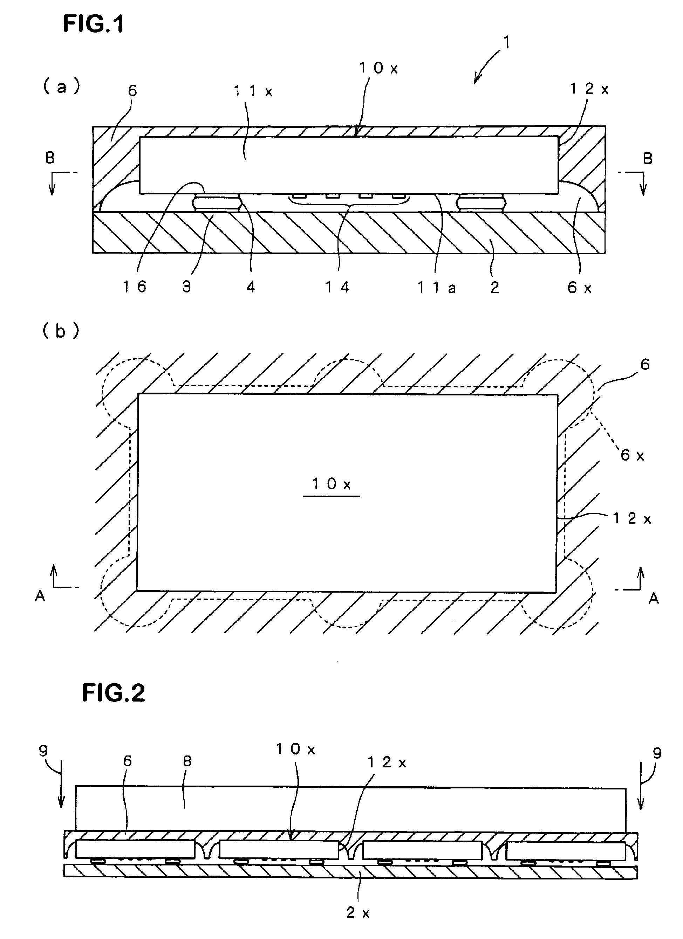

For example, a surface acoustic wave filter shown in cross-section in Fig. 1 has a device chip 10x mounted to a mount board 2 having an external terminal (not shown) by a flip chip pound mounting method and is, with a space being formed at a vibratory portion (surface acoustic wave propagation portion) of the device chip 10x, sealed with a resin film 6. The device chip 10x has a wiring pattern, which includes, for example, pads 16 and comb electrodes (IDTs) 14, formed on one surface 11a of a piezoelectric substrate 11x. Lands 3, which are metallic portions electrically connected to the external terminal of the mount board 2, and the pads 16 of the device chip 10x are electrically connected through bumps 4 such as metallic bumps including Au bumps or solder bumps.

In general, the surface acoustic wave filter sealed by the resin film 6 in this way is fabricated by a heat press method as shown in Fig. 2. More specifically, after mounting a plurality of device chips 10x to one board aggregate 2x by the flip chip pound mounting method, the device chips 10x are covered with the resin film 6. While heating the resin film 6, it is pressed in the direction of arrow 9 with a hot press 8 or by roll lamination. By this, the resin film 6 softened by heat is made to reach the mount board 2x from spaces between the device chips 10x that are adjacent to each other, and the device chips 10x are embedded in the resin film 6. By simultaneously dicing portions of the aggregate board 2x and portions of the resin film 6 between the adjacent device chips 10x, packages are severed into individual packages (refer to, for example, Patent Documents 1 and 2).
[Patent Document 1] Japanese Unexamined Patent Application Publication No. 2003-17979
[Patent Document 2] Japanese Unexamined Patent Application Publication No. 2003-32061

### Disclosure of Invention

### Problems to be Solved by the Invention

However, when the resin film 6 is pressed in with the hot press 8 or by roll lamination, air enters between the resin film 6 and peripheral surfaces 12x extending between a pair of principal surfaces of each piezoelectric substrate 11x, as a result of which large voids 6x may be formed near portions where the resin film 6 is in close contact with the board aggregate 2x, that is, the mount board 2.

More specifically, since the peripheral surfaces 12x of each piezoelectric substrate 11x are perpendicular to the pair of principal surfaces, at the initial stage of heat pressing the resin film 6, the resin film 6 is separated from the peripheral surfaces 12x of each piezoelectric substrate 11x, as a result of which, as shown in Fig. 1(b), the voids 6x may be formed due to air entering the corners or long sides of each rectangular piezoelectric substrate 11x.

When such large voids 6x are formed, the sealing width of the surface acoustic wave filter 1 (that is, the size of a portion where the film 6 and the mount board 2 are in close contact between the outside and the internal space of the surface acoustic wave filter 1) is reduced. Therefore, the surface acoustic wave filter 1 becomes less reliable particularly in terms of moisture resistance.

Accordingly, in view of such a situation, it is an object of the present invention is to provide a surface acoustic wave filter which can prevent the formation of large voids when pressing a resin sheet covering a device chip while heating the resin sheet, and a method of producing the same.

### Means for Solving the Problems

In order to overcome the aforementioned problems, the present invention provides a surface acoustic wave filter having the following structure.

To this end, according to a first aspect of the present invention, there is provided a surface acoustic wave filter comprising a mount board having a land, a device chip, and a resin film. In the device chip, a wiring pattern including an IDT and a pad electrically connected to the IDT is formed on one of a pair of parallel and opposing principal surfaces of a piezoelectric substrate, the pad being disposed so as to oppose the land of the mount board and the pad and the land being electrically connected through a bump. In the surface acoustic wave filter, the resin film covers the other principal surface of the piezoelectric substrate and seals the device chip. The one of the principal surfaces of the piezoelectric substrate is relatively large and the other principal surface of the piezoelectric substrate is relatively small. The size of a principal surface is reduced by removing a portion near an outer edge of the principal surface of the piezoelectric substrate.

According to the above-described structure, the area of the other principal surface of the piezoelectric substrate covered with the resin film is small, and the area of the one of the principal surfaces of the piezoelectric substrate to which the resin film reaches later by heat pressing carried out to press the resin film that is being heated is large. Therefore, during the heat pressing, the resin film can be as far as possible placed along the peripheral surfaces extending between the pair of principal surfaces of the piezoelectric substrate. By this, it is possible to prevent the reduction of the sealing width by preventing the formation of large voids.

More specifically, the structure may have various forms.

It is desirable that peripheral surfaces of the piezoelectric substrate extending between the pair of principal surfaces each have a parallel planar portion and a vertical planar portion, so that the peripheral surfaces of the piezoelectric substrate each have a stepped portion including at least one step. Each parallel planar portion is substantially parallel to the pair of principal surfaces of the piezoelectric substrate and each vertical planar portion is substantially perpendicular to the pair of principal surfaces of the piezoelectric substrate.

In this case, during heat pressing, the resin film contacts at least the parallel flat portion of each of the peripheral surfaces of the piezoelectric substrate. Therefore, although large voids grow when the resin film continues taking in air from the initial stage of the heat pressing, according to the above-described structure, the resin film does not continue taking in air, so that, even if the resin film takes in air, air bubbles that are formed are divided at the stepped portion of each of the peripheral surfaces of the piezoelectric substrate. What affects sealing are the voids formed by air bubbles at a final step of the one of the principal surfaces of the piezoelectric substrate, and these voids are reduced in size.

It is desirable that peripheral surfaces of the piezoelectric substrate extending between the pair of principal surfaces each have a tapering portion extending along an outer edge of the other principal surface of the piezoelectric substrate.

According to this structure, at the initial stage of heat pressing, the resin film does not easily take in air because the resin film gradually comes into contact with each tapering portion. Since, from the initial stage of the heat pressing, the resin film does not separate from the peripheral surfaces of the piezoelectric substrate and continue taking in air, it is possible to prevent the formation of large voids.

It is desirable that peripheral surfaces of the piezoelectric substrate extending between the pair of principal surfaces each have a curved portion extending along an outer edge of the other principal surface of the piezoelectric substrate.

According to the structure, since, at the initial stage of heat pressing, the resin film gradually comes into contact with the curved portion, the resin film does not easily take in air. Since, at the initial stage of the heat pressing, the resin film does not separate from the peripheral surfaces of the piezoelectric substrate and continue taking in air, it is possible to prevent the formation of large voids.

The present invention provides a method of producing a surface acoustic wave filter having the following structural feature.

According to a second aspect of the present invention, there is provided a method of producing surface acoustic wave filters comprising first to fourth steps. In the first step, a plurality of device chips are produced, each device chip having a wiring pattern formed on one of a pair of opposing principal surfaces of a piezoelectric substrate, each wiring pattern including an IDT and a pad electrically connected to the IDT. In the second step, the plurality of device chips that are spaced apart from each other are mounted to a board aggregate by disposing the one of the principal surfaces of each device chip so as to oppose the board aggregate and electrically connecting the one of the principal surfaces of each device chip to the board aggregate through a bump. In the third step, the device chips are sealed with a resin film by covering the device chips mounted to the board aggregate with the resin film and pressing the resin film that is being heated. In the fourth step, the surface acoustic wave filters are severed from each other by cutting portions of the resin film and the board aggregate between the device chips adjacent to each other. The first step includes forming the one of the principal surfaces of each piezoelectric substrate relatively large and the other principal surface of each piezoelectric substrate relatively small by removing a portion of each piezoelectric substrate near an outer edge of the other principal surface.

According to the above-described method, in the third step, the other principal surface of each piezoelectric substrate that is covered with the resin film from the beginning is small, and the one of the principal surfaces of each piezoelectric substrate to which the resin film reaches later is large, so that it is possible for the resin film to be placed along the peripheral surfaces of the piezoelectric substrates as far as possible. This makes it possible to prevent the reduction of the sealing width by preventing the formation of large voids.

### Advantages

According to the surface acoustic wave filter and the method of producing the same according to the present invention, it is possible to prevent the formation of large voids when pressing a resin sheet covering a device chip while heating the resin sheet.

### Brief Description of the Drawings

Fig. 1 is a sectional view of the structure of a surface acoustic wave filter. (Related Example)
Fig. 2 illustrates a method of producing surface acoustic wave filters. (Related Example)
Fig. 3 is a sectional view of the structure of a surface acoustic wave filter. (First Embodiment)
Fig. 4 illustrates a method of producing surface acoustic wave filters. (First Embodiment)
Fig. 5 is a sectional view of the structure of a surface acoustic wave filter. (Second Embodiment)
Fig. 6 illustrates a method of producing surface acoustic wave filters. (Second Embodiment)
Fig. 7 is a sectional view of the structure of a surface acoustic wave filter. (Modification of Second Embodiment)
Fig. 8 is a sectional view of the structure of a surface acoustic wave filter. (Modification of First Embodiment)

### Reference Numerals

- 2:: mount board
- 2x:: board aggregate
- 3:: land
- 4:: bump
- 6:: resin film
- 6a, 6b, 6c, 7a:: voids
- 10:: device chip
- 11:: piezoelectric substrate
- 11a:: principal surface
- 11b:: principal surface
- 12:: stepped portion
- 14:: IDT
- 16:: pad
- 20:: device chip
- 21:: piezoelectric substrate
- 21a:: principal surface
- 21b:: principal surface
- 22:: tapering portion
- 24:: IDT
- 26:: pad
- 30:: device chip
- 31:: piezoelectric substrate
- 31a:: principal surface
- 31b:: principal surface
- 32:: curved portion
- 34:: IDT
- 36:: pad

### Best Mode for Carrying Out the Invention

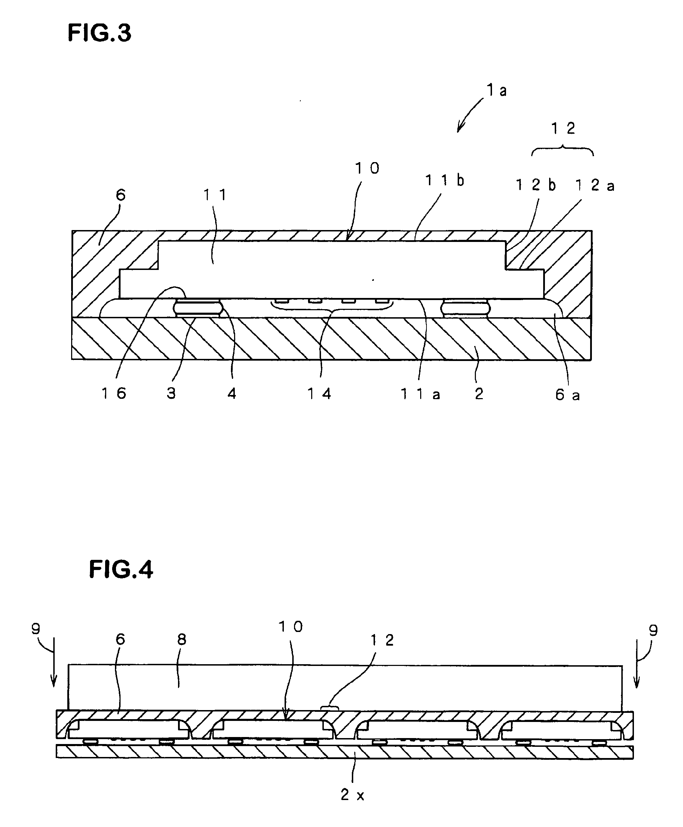

Hereunder, embodiments of the present invention will be described with reference to Figs. 3 to 8.

A surface acoustic wave filter 1a of a first embodiment will be described with reference to Figs. 3, 4, and 8. Parts corresponding to those of the related example shown in Figs. 1 and 2 are given the same reference numerals.

As shown in cross section in Fig. 3, the surface acoustic wave filter 1a has substantially the same structure as the related example shown in Figs. 1 and 2, has a device chip 10 which is mounted to a mount board 2 having an external terminal (not shown) by a flip chip pound mounting method, and is sealed with a resin film 6.

The device chip 10 has a wiring pattern, formed of a metallic film, disposed on one of a pair of parallel and opposing principal surfaces of a piezoelectric substrate 11, that is, a principal surface 11a. The wiring pattern includes, for example, IDTs 14, which are comb electrodes, and pads 16 electrically connected to the IDTs 14. The piezoelectric substrate 11 is formed of crystals, such as LiTaO₃ or LiNbO₃.

The mount board 2 has the external terminal (not shown) disposed on one of a pair of parallel and opposing principal surfaces and lands 3, which are metallic portions, disposed on the other principal surface. The external terminal and the lands 3 are electrically connected. The lands 3 are formed of, for example, Au.

The device chip 10 is disposed so that the principal surface 11a having the wiring pattern formed thereon opposes the principal surface of the mount board 2 having the lands 3 formed thereon, and the pads 16 of the device chip 10 and the lands 3 of the mount board 12 are electrically connected through bumps 4 such as metallic bumps including Au bumps or solder bumps. By the thickness of the bumps 4, a gap is formed between the device chip 10 and the mount board 12 so that a surface acoustic wave propagation portion of the principal surface 11a of the piezoelectric substrate 11 is not constrained.

Unlike the related example, the surface acoustic wave filter 1a is such that the area of the principal surface 11b of the piezoelectric substrate 11 not having the wiring pattern formed thereon is less than the area of the principal surface 11a having the wiring pattern formed thereon. Stepped portions 12 are formed at the peripheral surfaces extending between the principal surfaces 11a and 11b. Each stepped portion 12 has a parallel planar portion 12a and a vertical planar portion 12b, the parallel planar portion 12a being parallel to the principal surfaces 11a and 11b of the piezoelectric substrate 10, and the vertical planar portion 12b being perpendicular to the principal surfaces 11a and 11b of the piezoelectric substrate 10. Although, in Fig. 3, each stepped portion 12 has only one step, it may have two or more steps.

The stepped portions 12 of the piezoelectric substrate 11 may each be formed by, for example, dicing. More specifically, in a dicing step in which individual device chips 10 are severed from a wafer for the piezoelectric substrate 11, after forming a protective film of resist resin on the principal surface 11a of each piezoelectric substrate 11 having the wiring pattern formed thereon, grooves of predetermined depths are formed in the wafer for each piezoelectric substrate 11 from the principal surface 11b of each piezoelectric substrate 11 not having the wiring pattern formed thereon. After peeling off the resist resin of the protective layer and forming the bumps 4, formed of Au or the like, onto the pads 16, the device chips 10 are severed along the grooves, formed in the wafer for the piezoelectric substrates 11 with the dicer, while portions of the grooves are left, thereby severing the device chips 10 from each other. The portions of the grooves that are left in the device chips 10 become the stepped portions 12 of the piezoelectric substrates 11. Since the edges of the piezoelectric substrates 11 that have become thin by the grooves (stepped portions 12) tend to break as the depths of the grooves increase, it is desirable for the depth of cut of the grooves to be substantially 50%±15% of the thickness of the wafer for each piezoelectric substrate 11.

As a different method of forming the stepped portions 12 at the piezoelectric substrates 11, it is possible to use, for example, acid etching or dry etching using Ar gas. In this case, for an etching mask, a resist resin pattern having an opening at a portion where grooves to become the stepped portions 12 of the piezoelectric substrate 11 are formed is formed on the wafer for the piezoelectric substrates 11 by, for example, printing or photolithography.

As shown in Fig. 4, surface acoustic wave filters 1a are fabricated by the heat press method as in the related example.

First, the device chips 10 are mounted to one board aggregate 2x by the flip chip pound mounting method with spaces between the device chips 10 that are adjacent to each other. In other words, the bumps 4 previously formed on the pads 16 are joined to the lands 3 by bringing them into contact with the lands 3 while applying heat or ultrasonic waves.

Next, the device chips 10 are covered with the resin film 6, and, while heating the resin film 6, this is pressed towards the board aggregate 2x in the direction of arrow 9 with a hot press 8 or by roll lamination. By this, the resin film 6 softened by heat is made to reach the mount board 2x from the spaces between the adjacent device chips 10, and the device chips 10 are embedded in the resin film 6.

Next, portions of the resin film 6 and portions of the board aggregate 2x between the adjacent device chips 10 are simultaneously diced perpendicularly to the substrate aggregate 2x, so that the surface acoustic wave filters 1a are severed from each other.

Unlike the related example, the surface acoustic wave filters 1a are provided with the stepped portions 12 at the piezoelectric substrates 11. Therefore, when the resin film 6 is subjected to the heat pressing carried out to press the resin film 6 that is being heated, the resin film 6 contacts the parallel planar portions 12a of the stepped portions 12 of the piezoelectric substrates 11. Large voids grow when the resin film continues taking in air from the initial stage of the heat pressing, but, in the embodiment, the resin film does not continue taking in air due to the parallel planar portions 12a. Consequently, even if the resin film 6 takes in air, air bubbles that are formed are divided at the stepped portions 12 of the piezoelectric substrates 11, so that the volume of air taken in can be small. As a result, it is possible to reduce voids 6a that affect the sealing width. This makes it possible to make the sealing width greater than that in the related example, so that the filters can be made more reliable in terms of moisture resistance.

In a specific example, the gap between the device chip 10 and the mount board 2 is approximately 19 µm. When the device chips 11 are mounted to the board aggregate 2x, the adjacent device chips 11 are spaced apart so that an interval is approximately 300 µm when it is small and is approximately 800 µm when it is large. The initial thickness of the resin film 6 used to cover the device chip 11 is 250 µm.

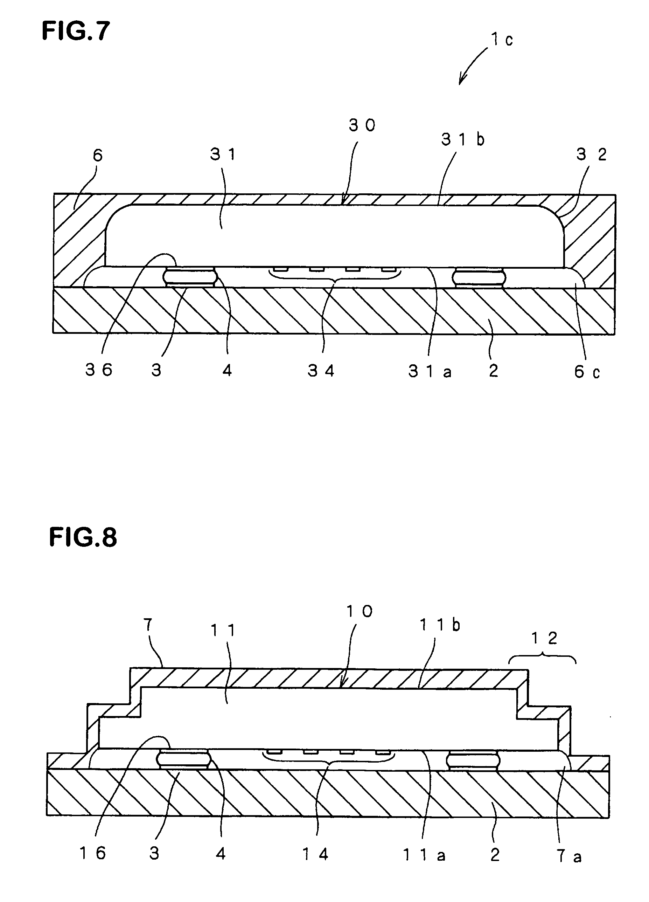

Although, in the example shown in Figs. 3 and 4, the sealing is carried out by using the relatively thick resin film 6, a relatively thin resin film 7 may also be used as shown in Fig. 8. Even if the resin film 7 is used for sealing, voids 7a can be made small, so that the filter can be made more reliable in terms of moisture resistance. In this case, a hot press or roller may have a form including a bumpy portion that is parallel with the external form (principal surfaces 11b and stepped portions 12) of the piezoelectric substrates 11.

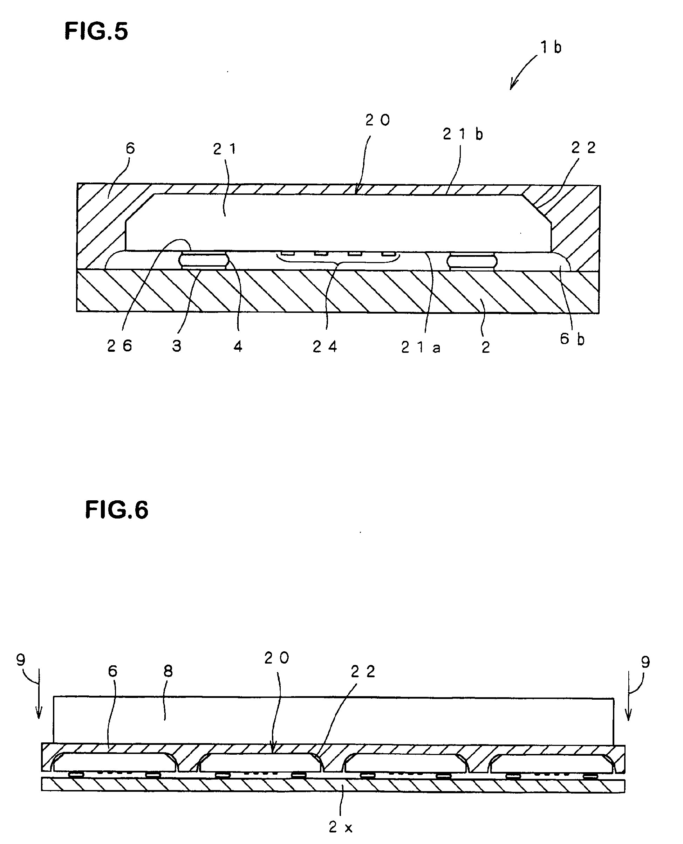

Next, a second embodiment will be described with reference to Figs. 5 to 7.

As shown in cross section in Fig. 5, a surface acoustic wave filter 1b has substantially the same structure as the filter of the first embodiment, has a device chip 20 mounted to a mount board 2 by the flip chip pound mounting method, and is covered with a resin film 6. A wiring pattern including IDTs 24 and pads 26 is formed on a principal surface 21a of a piezoelectric substrate 21. The pads 26 are electrically connected to the mount board 2 through bumps 4.

Unlike the first embodiment, the piezoelectric substrate 21 has tapering portions 22 formed by chamfering corners of the principal surface 21b not having the wiring pattern formed thereon. The tapering portions 22 are inclined surfaces extending obliquely from the outer edges of the principal surface 21b of the piezoelectric substrate 21 not having the wiring pattern formed thereon. Due to the tapering portions 22, of the two principal surfaces 21a and 21b of the piezoelectric substrate 21, the area of the principal surface 21b not having the wiring pattern formed thereon is less than the area of the principal surface 21a having the wiring pattern formed thereon.

Similarly to the first embodiment, as shown in Fig. 6, surface acoustic wave filters 1b can be fabricated by the heat press method. More specifically, a plurality of device chips 20 which are spaced apart are mounted to a board aggregate 2x by the flip chip pound mounting method. The device chips 20 are covered with a resin film 6. The resin film 6 that is being heated is pressed towards the board assembly 2x in the direction of arrow 9 with a hot press 8 or by roll lamination in order to seal the device chips 20. By simultaneously dicing portions of the board aggregate 2x and portions of the resin film 6 between the adjacent device chips 20 perpendicularly to the board aggregate 2x, the surface acoustic wave filters 1b are severed from each other.

Since, by providing the piezoelectric substrate 21 with the tapering portions 22, the resin film 6 is successively pressed in along the tapering portions 22 when pressing the resin film 6 that is being heated, it is possible to reduce the volume of air that the resin film 6 takes in. As a result, it is possible to reduce the size of voids 6b that affect the sealing width, so that the filter can be made more reliable in terms of moisture resistance.

Although, in Figs. 5 and 6, the corners of the piezoelectric substrate 21 are formed into tapering portions 22 that are linear in cross section, the corners of a piezoelectric substrate 31 may be rounded by forming curved portions 32 that are curved in cross section as in a surface acoustic wave filter 1c shown in Fig. 7. In this case, of principal surfaces 31a and 31b of the piezoelectric substrate 31, the area of the principal surface 31a having a wiring pattern including, for example, IDTs 34 and pads 36 is less than the area of the principal surface 31b not having the wiring pattern, so that, similarly to the case in which the tapering portions 22 are provided, voids 6c are smaller.

The tapering portions 22 and the curved portions 32 may be formed by dicing. In this case, dicer blades having cutting edge whose forms are properly designed for forming the tapering portions 22 and the curved portions 32, respectively, are used. For example, the tapering portions 22 may be formed by using a dicer blade that is V-shaped in cross section.

The tapering portions 22 and the curved portions 32 may be formed by acid etching or dry etching using Ar gas. In this case, print masks having opening patterns that are properly designed for forming the tapering portions 22 and the curved portions 32, respectively, (such as a print mask whose density is varied according to the etching depth) are used. In forming the tapering portions 22 or the curved portions 32 by dicing, since processing is carried out along four sides in the case where, for example, the rectangular piezoelectric substrate 21 or the rectangular piezoelectric substrate 31 is used, ridge lines are formed near the corners of the principal surface 21b or the principal surface 31b. When etching is carried out, a continuous form not having such ridge lines is easily formed.

As described above, of the principal surfaces 11a and 11b of the piezoelectric substrate 11, the principal surfaces 21a and 21b of the piezoelectric substrate 21, and the principal surfaces 31a and 31b of the piezoelectric substrate 31, the areas of the principal surfaces 11b, 21b, and 31b not having the respective wiring patterns are made less than the areas of the principal surfaces 11a, 21a, and 31a having the respective wiring patterns, so that it is possible to prevent the formation of large voids when pressing the resin sheets 6 covering the respective device chips 10, 20, and 30 while the resin sheets 6 are being heated.

The surface acoustic wave filter and the method of producing the same according to the present invention are not limited to those of the embodiments, so that various modifications may be made.

## Claims

1. A surface acoustic wave filter comprising:
a mount board having a land;
a device chip in which a wiring pattern including an IDT and a pad electrically connected to the IDT is formed on one of a pair of parallel and opposing principal surfaces of a piezoelectric substrate, the pad being disposed so as to oppose the land of the mount board, the pad and the land being electrically connected through a bump; and
a resin film covering the other principal surface of the piezoelectric substrate and sealing the device chip,
wherein the one of the principal surfaces of the piezoelectric substrate is relatively large and the other principal surface of the piezoelectric substrate is relatively small.

2. The surface acoustic wave filter according to Claim 1, wherein peripheral surfaces of the piezoelectric substrate extending between the pair of principal surfaces each have a parallel planar portion which is substantially parallel to the pair of principal surfaces of the piezoelectric substrate and a vertical planar portion which is substantially perpendicular to the pair of principal surfaces of the piezoelectric substrate, so that the peripheral surfaces of the piezoelectric substrate each have a stepped portion including at least one step.

3. The surface acoustic wave filter according to Claim 1, wherein peripheral surfaces of the piezoelectric substrate extending between the pair of principal surfaces each have a tapering portion extending along an outer edge of the other principal surface of the piezoelectric substrate.

4. The surface acoustic wave filter according to Claim 1, wherein peripheral surfaces of the piezoelectric substrate extending between the pair of principal surfaces each have a curved portion extending along an outer edge of the other principal surface of the piezoelectric substrate.

5. A method of producing surface acoustic wave filters comprising:
a first step of producing a plurality of device chips, each having a wiring pattern formed on one of a pair of opposing principal surfaces of a piezoelectric substrate, each wiring pattern including an IDT and a pad electrically connected to the IDT;
a second step of mounting the plurality of device chips that are spaced apart from each other to a board aggregate by disposing the one of the principal surfaces of each device chip so as to oppose the board aggregate and electrically connecting the one of the principal surfaces of each device chip to the board aggregate through a bump;
a third step of sealing the device chips with a resin film by covering the device chips mounted to the board aggregate with the resin film and pressing the resin film that is being heated; and
a fourth step of severing the surface acoustic wave filters from each other by cutting portions of the resin film and the board aggregate between the device chips adjacent to each other,
wherein the first step includes forming the one of the principal surfaces of each piezoelectric substrate relatively large and the other principal surface of each piezoelectric substrate relatively small by removing a portion of each piezoelectric substrate near an outer edge of the other principal surface.
